# EUROPEAN PATENT APPLICATION

(11) **EP 4 219 426 A1**
(43) Date of publication of application: **02.08.2023**
(21) Application number: 22215492.4
(22) Date of filing: 21.12.2022
(51) Int. Cl.: C04B 35/488, C04B 35/50, C04B 35/622

(54) **COMPOSITION**

(30) Priority: 01.02.2022 IN 202211005370
(71) Applicant: General Electric Company, Schenectady, NY 12345 (US)
(72) Inventor: NAYAK, Mohandas, 560066 Bengaluru (IN); KUMAR, Sundeep, 560066 Bengaluru (IN); PABLA, Surinder Singh, Greenville, 29615 (US)
(74) Representative: Openshaw & Co.

(57) **Abstract**

A composition comprising a rare earth solid solution, at least one of HfO₂ and CaZrO₃/MgZrO₃; and balance ZrO₂ The rare earth solid solution may include Gd₂O₃ and Lu₂O₃. In another example, the rare earth solid solution may include Gd₂O₃, Lu₂O₃, and at least one of Yb₂O₃ and Sm₂O₃.

## Description

The disclosure relates generally to a material composition. In particular, the disclosure relates generally to a material composition for a thermal barrier coating. Further, the disclosure relates generally to an ultra-low thermal (ULK) conductivity thermal barrier coating composition.

### BACKGROUND

Gas turbine systems are mechanisms for converting potential energy, in the form of fuel, to thermal energy and then to mechanical energy for use in propelling aircraft, generating electric power, pumping fluids etc. Gas turbine systems include a compressor section for supplying a flow of compressed combustion air, a combustor section for burning fuel in the compressed combustion air, and a turbine section for extracting thermal energy from the combustion air and converting that energy into mechanical energy in the form of a rotating shaft. One available avenue for improving efficiency of gas turbine systems is use of higher operating temperatures.

However, metallic materials used in gas turbine systems may be very near the upper limits of their thermal stability at current gas turbine operating temperatures. Modern high efficiency combustion gas turbine systems may have firing temperatures that exceed about 1,000 °C, and even higher firing temperatures are expected as the demand for more efficient engines continues. In the hottest temperature portions of gas turbine systems, some metallic materials may be used at temperatures above their melting points. The metallic materials may survive because they can be air cooled. However, air cooling may reduce overall gas turbine efficiency.

Thermal barrier coatings are applied to high temperature operating components, such as but not limited to those in gas turbine systems. With use of a thermal barrier coating, cooling air amounts can be substantially reduced. Thus, use of a thermal barrier coating can increase in gas turbine efficiency. Many components that form the "hot gas path" combustor and turbine sections are directly exposed to aggressive hot combustion gasses, for example, the combustor liner, the transition duct between the combustion and turbine sections, and the turbine stationary vanes and rotating blades and surrounding ring segments. In addition to thermal stresses, these and other components are also exposed to mechanical stresses and loads that further wear on the components.

Ceramic materials are generally used in thermal barrier coatings. Yttria-stabilized zirconia (YSZ) is a ceramic that is often used in thermal barrier coatings. The tetragonal or cubic crystal structure of zirconia or zirconium dioxide (ZrO₂) has been stabilized at room temperature by an addition of yttrium oxide or yttria (Y₂O₃) to form YSZ. However, tetragonal 8YSZ exhibits instability at higher temperatures and can decompose from its tetragonal crystal structure to a mixture of monoclinic and cubic zirconia, and thus not provide the full desired thermal barrier coating protection.

### BRIEF DESCRIPTION

All aspects, examples and features mentioned below can be combined in any technically possible way.

An aspect of the disclosure provides composition comprising a rare earth solid solution, at least one of HfO₂ and CaZrO₃/MgZrO₃; and balance ZrO₂, wherein the rare earth solid solution includes Gd₂O₃; and Lu₂O₃.

Another aspect of the disclosure includes any of the preceding aspects, and the composition is disposed on an 8YSZ layer.

Another aspect of the disclosure includes any of the preceding aspects, and the rare earth solid solution further includes at least one of Yb₂O₃ and Sm₂O₃, and the rare earth solid solution includes between about 30% and about 35% by weight Gd₂O_{3;} between about 30% and about 35% by weight Lu₂O₃; and between about 30% and about 35% by weight Yb₂O₃.

Another aspect of the disclosure includes any of the preceding aspects and the rare earth solid solution further includes at least one of Yb₂O₃ and Sm₂O_{3,} and the rare earth solid solution includes about 32% by weight of Gd₂O₃; about 34% by weight of Lu₂O₃; and about 34% by weight of Yb₂O₃.

Another aspect of the disclosure includes any of the preceding aspects, and the rare earth solid solution includes between about 45% and about 55% by weight) Gd₂O₃ and between about 45% and about 55% by weight Lu₂O₃.

Another aspect of the disclosure includes any of the preceding aspects, and the rare earth solid solution includes about 48% by weight Gd₂O₃ and about 52% by weight Lu₂O₃.

Another aspect of the disclosure includes any of the preceding aspects, and the rare earth solid solution includes between about 75% and about 85% by weight Gd₂O₃ and between about 15% and about 25% by weight Lu₂O₃.

Another aspect of the disclosure includes any of the preceding aspects, and the rare earth solid solution includes about 78% by weight Gd₂O₃ and about 22% by weight Lu₂O₃.

Another aspect of the disclosure includes any of the preceding aspects, and the rare earth solid solution further includes at least one of Yb₂O₃ and Sm₂O_{3,} and the rare earth solid solution includes between about 31% and about 41% by weight of Gd₂O_{3;} between about 31% and about 41% by weight Lu₂O₃; and between about 31% and about 41% by weight Sm₂O₃.

Another aspect of the disclosure includes any of the preceding aspects, and the rare earth solid solution includes about 33% by weight Gd₂O_{3;} about 36% by weight Lu₂O₃; and about 31% by weight Sm₂O₃.

Another aspect of the disclosure includes any of the preceding aspects, and the rare earth solid solution further includes at least one of Yb₂O₃ and Sm₂O_{3,} and the rare earth solid solution includes between about 35% and about 45% by weight Gd₂O₃; between about 8% and about 15% by weight Lu₂O₃; and between about 40% and about 50% by weight Sm₂O₃.

Another aspect of the disclosure includes any of the preceding aspects, and the rare earth solid solution includes about 43% by weight Gd₂O₃; about 11% by weight Lu₂O₃; and about 46% by weight Sm₂O₃.

Another aspect of the disclosure includes any of the preceding aspects and the rare earth solid solution further includes at least one of Yb₂O₃ and Sm₂O_{3,} and the rare earth solid solution includes between about 30% and about 40% by weight Gd₂O₃; between about 30% and about 40% by weight Lu₂O₃; and between about 30% and about 40% by weight Yb₂O₃.

Another aspect of the disclosure includes any of the preceding aspects, and the rare earth solid solution further includes at least one of Yb₂O₃ and Sm₂O_{3,} and the rare earth solid solution solid solution includes about 43% by weight Gd₂O₃; about 11% by weight Lu₂O₃; and about 46% by weight Yb₂O₃.

Another aspect of the disclosure includes any of the preceding aspects, and a ratio of ZrO₂ to rare earth solid solution is in a range between about 0.2 and about 0.7.

Another aspect of the disclosure includes any of the preceding aspects, and the composition includes at least one of HfO₂ and CaZrO₃/MgZrO₃ includes at least one of HfO₂ provided in a range between about 3% and about 10% by weight and CaZrO₃/MgZrO₃ in a range between about 2% and about 10% by weight.

Another aspect of the disclosure includes any of the preceding aspects, and the at least one of HfO₂ and CaZrO₃/MgZrO₃ includes only CaZrO₃/MgZrO₃.

Another aspect of the disclosure includes any of the preceding aspects, and the CaZrO₃/MgZrO₃ is provided in a range between about 2% and about 10% by weight.

An aspect of the disclosure provides component for a turbomachine, the component comprising a base component substrate; and a thermal barrier coating; wherein the thermal barrier coating includes a rare earth solid solution, at least one of HfO₂ and CaZrO₃/MgZrO₃; and balance ZrO₂, and the rare earth solid solution including Gd₂O₃; Lu₂O₃; and at least one of Yb₂O₃ and Sm₂O₃.

Another aspect of the disclosure includes any of the preceding aspects, and wherein the rare earth solid solution includes between about 30% and about 40% by weight Gd₂O₃; between about 30% and about 40% by weight Lu₂O₃; and between about 30% and about 40% by weight of at least one of Yb₂O₃.

Another aspect of the disclosure includes any of the preceding aspects, and wherein the rare earth solid solution includes between about 30% and about 40% by weight Gd₂O₃; between about 30% and about 40% by weight Lu₂O₃; and between about 30% and about 40% by weight) of Sm₂O₃.

Two or more aspects described in this disclosure, including those described in this summary section, may be combined to form implementations not specifically described herein.

The details of one or more implementations are set forth in the accompanying drawings and the description below. Other features, objects and advantages will be apparent from the description and drawings, and from the claims.

### BRIEF DESCRIPTION OF THE DRAWINGS

These and other features of this disclosure will be more readily understood from the following detailed description of the various aspects of the disclosure taken in conjunction with the accompanying drawings that depict various embodiments of the disclosure, in which:
FIG. 1 is a schematic sectional view of a thermal barrier coating on a turbomachine component, according to embodiments of the disclosure;
FIG. 2 is a table of compositions in mol percentages and weight percentages, according to embodiments of the disclosure; and
FIG. 3 illustrates a graph of thermal conductivity versus firing temperature for compositions, according to embodiments of the disclosure.

It is noted that the drawings of the disclosure are not necessarily to scale. The drawings are intended to depict only typical aspects of the disclosure and therefore should not be considered as limiting the scope of the disclosure. In the drawings, like numbering represents like elements between the drawings.

### DETAILED DESCRIPTION

As an initial matter, in order to clearly describe the subject matter of the current disclosure, it will become necessary to select certain terminology when referring to metallurgy and describing relevant thermal barrier coatings and compositions, especially with use in a gas turbine system's technology and components. To the extent possible, common industry terminology will be used and employed in a manner consistent with its accepted meaning. Unless otherwise stated, such terminology should be given a broad interpretation consistent with the context of the present application and the scope of the appended claims. Those of ordinary skill in the art will appreciate that often a particular component may be referred to using several different or overlapping terms. What may be described herein as being a single part may include and be referenced in another context as consisting of multiple components. Alternatively, what may be described herein as including multiple components may be referred to elsewhere as a single part.

In addition, several descriptive terms may be used regularly herein, and it should prove helpful to define these terms at the onset of this section. These terms and their definitions, unless stated otherwise, are as follows.

In addition, several descriptive terms may be used regularly herein, as described below. The terms "first", "second", and "third" may be used interchangeably to distinguish one component from another and are not intended to signify location or importance of the individual components.

The terminology used herein is for the purpose of describing particular embodiments only and is not intended to be limiting of the disclosure. As used herein, the singular forms "a", "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components but do not preclude the presence or addition of one or more other features, integers, steps, operations, elements, components, and/or groups thereof. "Optional" or "optionally" means that the subsequently described event or circumstance may or may not occur or that the subsequently describe component or element may or may not be present, and that the description includes instances where the event occurs or the component is present and instances where it does not or is not present.

Where an element or layer is referred to as being "on," "engaged to," "connected to" or "coupled to" another element or layer, it may be directly on, engaged to, connected to, or coupled to the other element or layer, or intervening elements or layers may be present. In contrast, when an element is referred to as being "directly on," "directly engaged to," "directly connected to" or "directly coupled to" another element or layer, there may be no intervening elements or layers present. Other words used to describe the relationship between elements should be interpreted in a like fashion (e.g., "between" versus "directly between," "adjacent" versus "directly adjacent," etc.). As used herein, the term "and/or" includes any and all combinations of one or more of the associated listed items.

As discussed above, gas turbine systems convert potential energy to thermal energy and then to mechanical energy for use. Improving efficiency of a gas turbine is desirable and that improvement can be achieved by operating the gas turbine at higher temperatures. However, metallic materials used in gas turbines, especially at higher temperatures associated with hot gas path components may be very near the upper limits of their thermal stability at gas turbine operating conditions. In the hottest portions of gas turbines, some metallic materials may even be used at temperatures above their melting points. The metallic materials can survive because they can be cooled, for example, by air, steam, or other cooling schema now known or hereinafter developed. However, cooling may reduce overall gas turbine efficiency.

Thermal barrier coatings may be applied to high temperature operating components, such as but not limited to, in gas turbine systems. With thermal barrier coatings, cooling air amounts for gas turbines can be reduced. Thus, thermal barrier coatings can increase gas turbine efficiency. Thermal barrier coatings can be applied to hot gas path components, such as but not limed to combustion liners, transition pieces, turbine nozzles, and turbine blades/buckets.

Generally speaking, metallic materials, including those in gas turbines, have coefficients of thermal expansion that exceed those of ceramic materials. Consequently, ceramic materials in a thermal barrier coating should match its coefficient of thermal expansion to the coefficient of thermal expansion of the component substrate. Therefore, upon heating when the substrate expands, the ceramic coating material does not crack. Zirconium dioxide ZrO₂ ("zirconia") and hafnium dioxide HfO₂ ("hafnia") both exhibit a high coefficient of thermal expansion, and thus zirconia and hafnia are often used in thermal barrier coatings.

Thermal barrier coatings can be deposited by several techniques. As embodied by the disclosure, deposition techniques include, but are not limited to, thermal spraying (plasma, flame, and high velocity oxygen fuel [HVOF]), sputtering, and electron beam physical vapor deposition (EBPVD). Electron beam physical vapor deposition may produce a columnar grain microstructure that includes small columns separated by gaps which extend into the coating. This structure may be referred to as dense vertically cracked or DVC TBC.

TBC systems can include at least one layer provided on a metal substrate. The metal substrate is often a component, such as a turbomachine component. The turbomachine component can include a hot gas path component. A common TBC is yttria-stabilized zirconia (YSZ) often referred to as a low K (LK) TBC, which has a relatively low thermal conductivity (K) while remaining stable at nominal operating temperatures typically seen in turbomachine applications.

TBCs fail (or spall) through various degradation modes that include mechanical rumpling of the bond coat during thermal cyclic exposure, accelerated oxidation, hot corrosion, and molten deposit degradation. With the loss of the TBC, the component may experience much higher temperatures and component life may be reduced dramatically. Accordingly, a TBC composition with enhanced thermal conductivity lower than ULK compositions can enhance turbine life.

As noted above, a higher firing temperature may be required to increase efficiency of gas turbines. Increase firing temperature requires the temperature at a metal interface of a component and TBC to be at a level to avoid spalling, adverse component expansion, or other undesirable effects. Thus, a reduced (low) thermal conductivity TBC can enable enhanced turbomachine efficiency by enabling increased turbine firing temperature (T-fire).

Also, a low thermal conductivity (K) TBC may avoid requiring an increased TBC thickness to accommodate an increased turbine T-fire. If a ULK TBC, as embodied by the disclosure, is provided a thickness of the TBC may remain constant even with increased T-fire of a turbomachine. Additionally, if a turbine's T-fire is maintained, constant cost reduction may be realized with a ULK TBC, as embodied by the disclosure. In this scenario, a thickness of the ULK TBC, as embodied by the disclosure, can be reduced to provide comparable protection to turbomachine component.

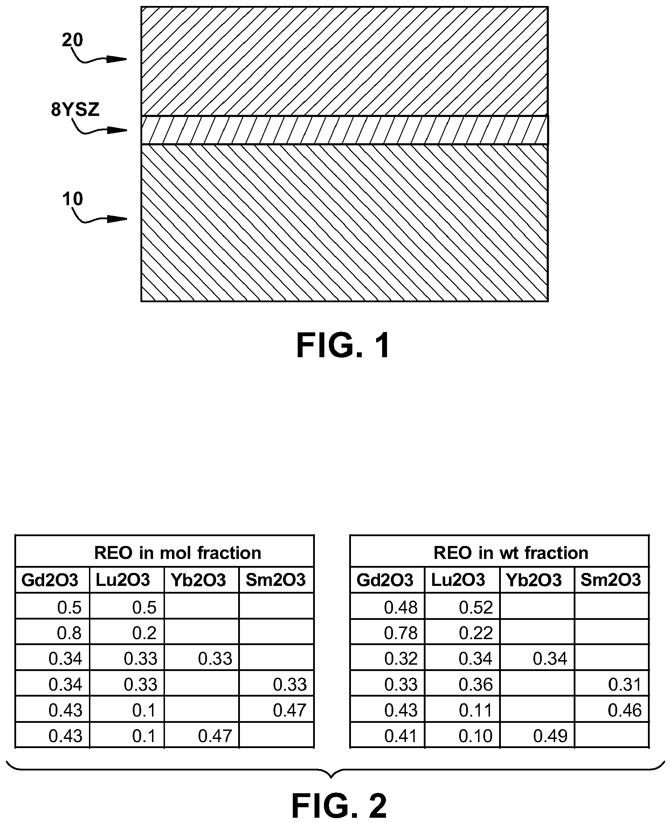

With reference to FIG. 1, a composition, as embodied by the disclosure, includes an ultra-low thermal conductivity (ULK) composition. The ULK composition can be provided as an ULK thermal barrier coating (TBC) layer 20. Further, ULK TBC layer 20 can be provided as a protective layer on a component 10, for example on a bond coat, where the bond coat may also be part of a multi-layered coating. For example, the composition, as embodied by the disclosure, can be applied onto an 8YSZ inner layer and then a bond coat. Component 10 may be subjected to elevated temperatures, for example temperatures encountered by a hot gas path component in turbines. Turbines may include, but are not limited to, land-based gas turbines. Hot gas path components include, but are not limited to, combustion liners, transition pieces, turbine nozzles, and turbine blades (also known as "turbine buckets").

FIG. 2 includes a table of various ULK compositions, as embodied by the disclosure. ULK compositions include rare earth oxides as a solid solution in zirconium oxide (ZrO₂). In the context of the embodiments, a solid solution is a solid mixture containing a minor component distributed within the crystal lattice of a major component. Often the distribution of the minor component within the crystal lattice of the major component is a uniform distribution., such as over an 8YSZ inner layer of TBC, which provides chemical compatibility with the bond coat and is a tough layer for thermal and mechanical stress relief.

The composition, as embodied by the disclosure, contains constituents including a rare earth solid solution; at least one of hafnium oxide (HfO₂) and calcium zirconate/perovskite (CaZrO₃/MgZrO₃); and zirconium dioxide (ZrO₂) as the balance of the composition. The rare earth solid solution can include gadolinium (III) oxide (Gd₂O₃) and lutetium oxide (Lu₂O₃). Further, the rare earth solid solution can include gadolinium (III) oxide (Gd₂O₃); lutetium oxide (Lu₂O₃); and at least one of ytterbium oxide (Yb₂O₃) and samarium (III) oxide (Sm₂O₃).

Constituents of the rare earth solid solution can include Gd₂O₃; Lu₂O₃; and Yb₂O₃, each in a range between about 30% and about 40% by mol (between about 30% and about 40% by weight). Also, the rare earth solid solution, as embodied by the disclosure, can include equal amounts of constituents Gd₂O₃; Lu₂O₃; and Yb₂O₃. In other words, each of Gd₂O₃; Lu₂O₃; and Yb₂O₃ being about 33% by mol (about 32% Gd₂O₃; about 34% Lu₂O₃; and about 34% Yb₂O₃ by weight) of the rare earth solid solution.

In a further composition of the rare earth solid solution, rare earth solid solution constituents can include between about 45% and about 55% by mol (between about 45% and about 55% by weight) Gd₂O₃ and between about 45% and about 55% by mol (between about 45% and about 55% by weight) Lu₂O₃. Further, rare earth solid solution can include about 50% by mol (about 48% by weight) Gd₂O₃ and about 50% by mol (about 52% by weight) Lu₂O₃.

In a further aspect, as embodied by the disclosure, the rare earth solid solution constituents can include between about 75% and about 85% by mol (between about 75% and about 85% by weight) of Gd₂O₃ and between about 15% and about 25% by mol (between about 15% and about 25% by weight) of Lu₂O₃. In a certain composition of the rare earth solid solution, the rare earth solid solution may include about 80% by mol (about 78% by weight) of Gd₂O₃ and about 20% by mol (about 22% by weight) of LuxOs.

Additionally, rare earth solid solution constituents can include Gd₂O₃; Lu₂O₃; and Sm₂O₃ each in a range between about 30% and about 40% by mol (between about 30% and about 40% by weight). Also, the rare earth solid solution, as embodied by the disclosure, can include equal amounts of Gd₂O₃; Lu₂O₃; and Sm₂O₃, or in other words each of Gd₂O₃; Lu₂O₃; and Sm₂O₃ being about 33% by mol (about 33% Gd₂O₃; about 36% Lu₂O₃; and about 31% Sm₂O₃ by weight) of the rare earth solid solution.

Moreover, rare earth solid solution constituents of the composition may include between about 40% and about 45% by mol (between about 40% and about 50% by weight) Gd₂O₃; between about 8% and about 12% by mol (8% and about 12% by weight) Lu₂O₃; and between about 45% and about 50% by mol (between about 45% and about 50% by weight) Sm₂O₃. Also, in an additional aspect of the composition, the composition may include about 43% by mol (about 43% by weight) Gd₂O₃; about 10% by mol (about 11% by weight) Lu₂O₃; and about 47% by mol (about 46% by weight) Sm₂O₃.

Also, the composition can include ZrO₂ and rare earth solid solution in a ratio range between about 0.2 and about 0.7.

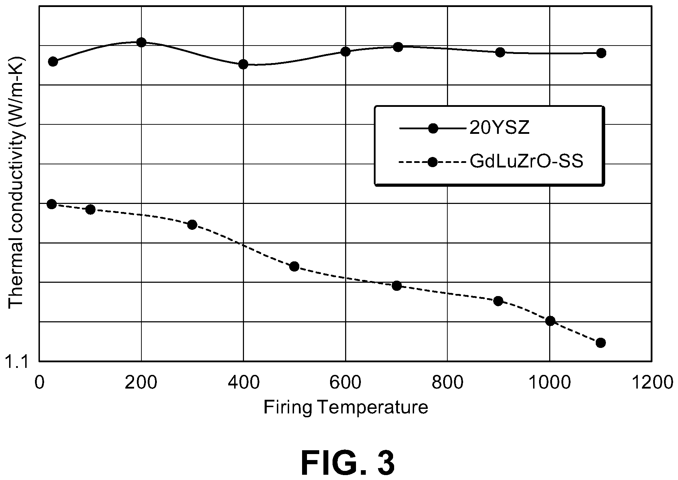

The composition, as embodied by the disclosure, may exhibit about an 8% lower thermal conductivity (K) than common low K compositions. Further, the composition can exhibit about a thermal conductivity (K) about 44% lower than 20wt% YSZ. FIG. 3 illustrates a graph of thermal conductivity (W/m-K) versus firing temperature for compositions, according to embodiments of the disclosure. The graph of FIG. 3 illustrates the difference between 20wt% YSZ and a composition (Gd,Lu)Zr₂O₇, as embodied by the disclosure, that includes a rare earth solid solution including about 50% by mol (about 48% by weight) Gd₂O₃ and about 50% by mol (about 52% by weight) Lu₂O₃. The curve for 20%wt YSZ does not exhibit low thermal conductivity at elevated firing temperatures compared to the compositions, as embodied by the disclosure. Thermal conductivity of an illustrative material, (Gd,Lu)Zr₂O₇, is in a range between about 1.32 and about 1.5 W/m-K at 1000⁰C and exhibits a downward trend at higher temperatures.

The composition, as embodied by the disclosure, may include an additive to enhance sinter resistance. The additive may include at least one of HfO₂, such as HfO₂ in a range between about 3% and about 10% by weight, and CaZrO₃/MgZrO₃, such as CaZrO₃/MgZrO₃ in a range between about 2% and about 10% by weight. Additives HfO₂ and CaZrO₃/MgZrO₃ may enhance sinter resistance. Sinter resistance, as embodied by the disclosure, means a material's density is substantially unchanged after aging at high temperature for an extended period of time, for example, in the context of turbomachines aging at high temperatures that occurs by elongated use at operating temperatures of a turbine. Sinter resistance is an important characteristic of TBCs, such as but not limited to thermally sprayed TBCs and dense vertically cracked (DVC) TBCs (DVC-TBC) to withstand strain after aging at high temperatures. A capability of a coating (TBC) to manage strain through sinter resistance modification is reduced if vertical cracks formed in the coating/TBC sinter together during sintering. As embodied by the disclosure, sinter resistance may result in an increase in ZrO₂ density with the addition of at least one of HfO₂ and CaZrO₃/MgZrO₃ in a range between about a 0% and about 3% by weight.

Approximating language, as used herein throughout the specification and claims, may be applied to modify any quantitative representation that could permissibly vary without resulting in a change in the basic function to which it is related. Accordingly, a value modified by a term or terms, such as "about," "approximately" and "substantially," are not to be limited to the precise value specified. In at least some instances, the approximating language may correspond to the precision of an instrument for measuring the value. Here and throughout the specification and claims, range limitations may be combined and/or interchanged; such ranges are identified and include all the sub-ranges contained therein unless context or language indicates otherwise. "Approximately" and "about" as applied to a particular value of a range, applies to both end values and, unless otherwise dependent on the precision of the instrument measuring the value, may indicate +/- 10% of the stated value(s).

The corresponding structures, materials, acts, and equivalents of all means or step plus function elements in the claims below are intended to include any structure, material, or act for performing the function in combination with other claimed elements as specifically claimed. The description of the present disclosure has been presented for purposes of illustration and description but is not intended to be exhaustive or limited to the disclosure in the form disclosed. Many modifications and variations will be apparent to those of ordinary skill in the art without departing from the scope and spirit of the disclosure. The embodiment was chosen and described in order to best explain the principles of the disclosure and the practical application and to enable others of ordinary skill in the art to understand the disclosure for various embodiments with various modifications as are suited to the particular use contemplated.

## Claims

1. A composition comprising:
a rare earth solid solution including Gd₂O₃ and Lu₂O₃;
at least one of HfO₂ and CaZrO₃/MgZrO₃; and
balance ZrO₂.

2. The composition according to claim 1, wherein the composition is disposed on an 8YSZ layer.

3. The composition according to claim 1, wherein the rare earth solid solution further includes at least one of Yb₂O₃ and Sm₂O₃, and the rare earth solid solution includes:
between about 30% and about 35% by weight Gd₂O_{3;}
between about 30% and about 35% by weight Lu₂O₃; and
between about 30% and about 35% by weight of at least one of Yb₂O₃ and Sm₂O_{3.}

4. The composition according to claim 1, wherein the rare earth solid solution further includes at least one of Yb₂O₃ and Sm₂O₃, and the rare earth solid solution includes:
about 32% by weight Gd₂O₃;
about 34% by weight Lu₂O₃; and
about 34% by weight of the at least one of Yb₂O₃ and Sm₂O₃.

5. The composition according to claim 1, wherein the rare earth solid solution includes between about 45% and about 55% by weight Gd₂O₃ and between about 45% and about 55% by weight Lu₂O_{3.}

6. The composition according to claim 1, wherein the rare earth solid solution includes about 48% by weight Gd₂O₃ and about 52% by weight Lu₂O₃.

7. The composition according to claim 1, wherein the rare earth solid solution includes between about 75% and about 85% by weight Gd₂O₃ and between about 15% and about 25% by weight Lu₂O₃.

8. The composition according to claim 1, wherein the rare earth solid solution includes about 78% by weight Gd₂O₃ and about 22% by weight Lu₂O₃.

9. The composition according to claim 1, wherein the rare earth solid solution further includes at least one of Yb₂O₃ and Sm₂O₃, and the rare earth solid solution includes:
between about 30% and about 40% by weight Gd₂O_{3;}
between about 30% and about 40% by weight Lu₂O₃; and
between about 30% and about 40% by weight of the at least one of Yb₂O₃ and Sm₂O₃.

10. The composition according to claim 1, wherein the rare earth solid solution further includes at least one of Yb₂O₃ and Sm₂O₃, and the rare earth solid solution includes:
about 33% by weight Gd₂O_{3;}
about 30% by weight Lu₂O₃; and
about 31% by weight of at least one of Yb₂O₃ and Sm₂O₃.

11. The composition according to claim 1, wherein the rare earth solid solution further includes at least one of Yb₂O₃ and Sm₂O₃, and the rare earth solid solution includes:
between about 35% and about 45% by weight Gd₂O₃;
between about 9% and about 12% by weight Lu₂O₃; and
between about 45% and about 55% by weight Sm₂O₃.

12. The composition according to claim 1, wherein the rare earth solid solution further includes at least one of Yb₂O₃ and Sm₂O₃, and the rare earth solid solution includes about 43% by weight Gd₂O₃; about 11% by weight Lu₂O₃; and about 46% by weight Sm₂O₃.

13. The composition according to claim 1, the rare earth solid solution further includes at least one of Yb₂O₃ and Sm₂O₃, and the rare earth solid solution includes between about 40% and about 45% by weight Gd₂O₃; between about 8% and about 15% by weight Lu₂O₃; and between about 40% and about 50% by weight Yb₂O₃.

14. The composition according to claim 1, wherein the rare earth solid solution further includes at least one of Yb₂O₃ and Sm₂O₃, and the rare earth solid solution includes about 43% by weight Gd₂O₃; about 11% by weight Lu₂O₃; and about 46% by weight Yb₂O₃.

15. The composition according to claim 1, wherein a ratio of ZrO₂ to rare earth solid solution is in a range between about 0.2 and about 0.7.
